# EUROPEAN PATENT APPLICATION

(11) **EP 3 627 555 A1**
(43) Date of publication of application: **25.03.2020**
(21) Application number: 19201786.1
(22) Date of filing: 21.12.2005
(51) Int. Cl.: H01L 27/146, H01L 27/14, G01T 1/164, H01L 31/107

(54) **PHOTODIODE ARRAY**

(30) Priority: 24.12.2004 JP 2004374062
(62) Divisional of application: 05820225.0
(71) Applicant: HAMAMATSU PHOTONICS K. K., Hamamatsu-shi Shizuoka 435-8558 (JP)
(72) Inventor: ISHIKAWA, Yoshitaka, Hamamatsu-shi, Shizuoka 435-8558 (JP)
(74) Representative: Boult Wade Tennant LLP

(57) **Abstract**

A photodiode array (1, 20, 22) comprising a plurality of photodetecting channels (10) which are formed in a semiconductor substrate (2) and light to be detected is made to enter; an accumulation layer (7A) or accumulation layers (7) having an impurity concentration higher than in the semiconductor substrate (2), the accumulation layer (7A) or the accumulation layers (7) formed at an incident surface side of the semiconductor substrate (2), the accumulation layers (7) being electrically connected to each other; PN junctions of multipliers formed at an opposite surface side of the incident surface of the semiconductor substrate (2), each of the multipliers avalanche-multiplying carriers; resistors (42), each formed on the opposite surface side of the incident surface and electrically connected to the multipliers; and separators (5) formed around and separating the photodetecting channels (10), the accumulation layers (7), the multipliers (6) and the resistors (42) being respectively formed for each of the respective photodetecting channels (10), or the accumulation layer (7A) being formed over an entire surface of the incident surface side of the semiconductor substrate (2) while the multipliers (6) and the resistors (42) being respectively formed for each of the respective photodetecting channels (10).

## Description

### Technical Field

The present invention relates to a photodiode array to be used for photon counting by being operated in Geiger mode.

### Background Art

For example, in chemical and medical fields, there is a technique of photon counting by attaching a photodiode array using avalanche (electron avalanche) multiplication to a scintillator. In such a photodiode array, in order to discriminate a plurality of photons which simultaneously enter, a plurality of divided photodetecting channels are formed on a common substrate, and for each photodetecting channel, a multiplier is arranged (for example, refer to Non-patent Document 1 and Non-patent Document 2).

Each multiplier is operated under operating conditions called Geiger mode in order to satisfactorily detect faint light. That is, a reverse voltage higher than a breakdown voltage is applied to each multiplier, and the phenomenon in which carriers generated due to photons that entered are avalanche-multiplied is used. On the other hand, a resistor for extracting an output signal from the multiplier is connected to each photodetecting channel, and the resistors are connected in parallel to each other. Photons that entered the photodetecting channels are detected based on a crest value of the output signal extracted to the outside via each resistor.
Non-patent Document 1: P. Buzhan, et al., "An Advanced Study of Silicon Photomultiplier" (online), ICFA Instrumentation BULLETIN Fall 2001 Issue, (searched on Nov. 4, 2004), (URL: http://www.slac.stanford.edu/pubs/icfa/)
Non-patent Document 2: P. Buzhan, et al., "Silicon Photomultiplier And Its Possible Applications," Nuclear Instruments and Methods in Physics Research A 504(2003) 48-52

### Disclosure of the Invention

### Problem to be Solved by the Invention

When a photodiode array is used for photon counting, to obtain satisfactory results, it is important to increase quantum efficiency by raising the aperture ratio with respect to light to be detected and restrain crosstalk between photodetecting channels caused by operation in Geiger mode.

However, in the above-described photodiode array, to restrain crosstalk between photodetecting channels caused during operation in Geiger mode, it is necessary to space the multipliers from each other to some degree. This results in lowering in aperture ratio with respect to light to be detected, and it is difficult to improve the detection sensitivity.

The present invention was made in order to solve the problem, and an object thereof is to provide a photodiode array which can secure a sufficient aperture ratio with respect to light to be detected while restraining crosstalk between photodetecting channels even during operation in Geiger mode.

### Means for Solving the Problem

To solve the problem, a photodiode array relating to the present invention is a photodiode array obtained by forming, on a semiconductor substrate, a plurality of photodetecting channels which light to be detected is made to enter, and on an incident surface side which light to be detected enters of the semiconductor substrate, an accumulation layer having an impurity concentration higher than that of the semiconductor substrate is formed, and on a side opposite to the entrance surface of the semiconductor substrate, multipliers for avalanche-multiplying carriers generated due to incidence of light to be detected and resistors which are electrically connected to the multipliers and are connected in parallel to each other are formed for the respective photodetecting channels, and the photodetecting channels are separated from each other by separators formed around the respective multipliers.

In this photodiode array, resistors to be electrically connected to the respective multipliers are collectively formed on the side opposite to the light-incident surface of the semiconductor substrate. Therefore, no resistor is interposed on the incident surface side which light to be detected enters, so that gaps between the photodetecting channels can be narrowed except for the forming regions of the separators. As a result, it becomes possible to secure a sufficient aperture ratio with respect to light to be detected while restraining crosstalk between photodetecting channels by the separators. Furthermore, on the incident surface side which light to be detected enters, an accumulation layer having an impurity concentration higher than that of the semiconductor substrate is formed, so that carriers generated in the semiconductor substrate can be restrained from being recombined near the incident surface side. Thereby, high quantum efficiency in each photodetecting channel is secured, so that improvement in effective aperture ratio with respect to light to be detected is realized.

The separators are preferably formed by trenches. By employing trenches as separators, narrow separators can be formed, so that the aperture ratio with respect to light to be detected is more reliably secured.

In the trenches, a low-refractive-index material having a refractive index lower than that of the semiconductor substrate is preferably formed. Thereby, plasma emission generated in each multiplier under operating conditions of Geiger mode is reflected by the low-refractive-index material, and is restrained from reaching adjacent photodetecting channels. Thereby, optical crosstalk can be restrained.

The low-refractive-index material is preferably made of SiO₂. In this case, a sufficient refractive index difference can be made between the low-refractive-index material and the semiconductor substrate. Therefore, plasma emission can be more reliably reflected by the low-refractive-index material, and optical crosstalk can be more effectively restrained. Furthermore, SiO₂ has high insulation, so that electrical crosstalk can also be effectively restrained.

The trench and the low-refractive-index material are preferably formed so as to penetrate the semiconductor substrate from the incident surface side to the opposite surface side. Thereby, adjacent photodetecting channels are more reliably separated from each other, so that optical crosstalk and electrical crosstalk can be more effectively restrained.

It is preferable that the accumulation layers are formed for the respective photodetecting channels, and the accumulation layers are electrically connected to each other by a transparent electrode layer formed on the incident surface side of the semiconductor substrate. Thereby, photodetecting channels are conducted to each other by the transparent electrode layer, and the same potential can be maintained. In this case, the accumulation layer lowers contact resistance between the semiconductor substrate and the transparent electrode layer, and a satisfactory contact can be formed.

### Effect of the Invention

As described above, according to the photodiode array relating to the present invention, even during operation in Geiger mode, a sufficient aperture ratio with respect to light to be detected can be secured while restraining crosstalk between photodetecting channels.

Further aspects of the present disclosure as set forth in the following numbered clauses:
Clause 1. A photodiode array having a plurality of photodetecting channels which is formed in a semiconductor substrate and light to be detected is made to enter, wherein:
   on an incident surface side for the light to be detected of the semiconductor substrate,
   accumulation layers having an impurity concentration higher than in the semiconductor substrate are formed,
   on an opposite surface side of the incident surface of the semiconductor substrate,
   multipliers for avalanche-multiplying carriers generated due to incidence of the light to be detected; and
   resistors which are electrically connected to the multipliers and are connected in parallel to each other, are formed for the respective photodetecting channels, and
   the photodetecting channels are separated from each other by separators formed around the respective multipliers.
Clause 2. The photodiode array according to Clause 1, wherein the separators are formed by trenches.
Clause 3. The photodiode array according to Clause 2, wherein in the trenches, a low-refractive index material having a refractive index lower than that of the semiconductor substrate is formed.
Clause 4. The photodiode array according to Clause 3, wherein the low-refractive index material is made of SiO₂.
Clause 5. The photodiode array according to Clause 4, wherein the trench and the low-refractive-index material are formed so as to penetrate the semiconductor substrate from the incident surface side to the opposite surface side.
Clause 6. The photodiode array according to Clause 1, wherein
   the accumulation layers are formed for the respective photodetecting channels, and
   the accumulation layers are electrically connected to each other by a transparent electrode layer formed on the incident surface side of the semiconductor substrate.

### Brief Description of the Drawings

Fig. 1 is a view of a photodiode array of a first embodiment of the present invention from a light-incident surface side;
Fig. 2 is a view of the photodiode array of Fig. 1 from an opposite side of the light-incident surface;
Fig. 3 is a sectional view along the III-III line of Fig. 2;
Fig. 4-(a) is a sectional view showing a manufacturing process of the photodiode array of Fig. 1, Fig. 4-(b) is a sectional view of a subsequent manufacturing process, and Fig. 4-(c) is a further subsequent manufacturing process;
Fig. 5-(a) is a sectional view showing a manufacturing process subsequent to Fig. 4-(c), and Fig. 5-(b) is a sectional view showing a manufacturing process subsequent to Fig. 5-(a);
Fig. 6-(a) is a sectional view showing a manufacturing process subsequent to Fig. 5-(b), and Fig. 6-(b) is a sectional view showing a manufacturing process subsequent to Fig. 6-(a);
Fig. 7 is a sectional view showing an exemplary variation of the photodiode array of the first embodiment;
Fig. 8 is a sectional view showing a photodiode array of a second embodiment of the present invention;
Fig. 9-(a) is a sectional view showing a manufacturing process of the photodiode array of Fig. 8, and Fig. 9-(b) is a sectional view showing a subsequent manufacturing process;
Fig. 10(a) is a sectional view showing a manufacturing process subsequent to Fig. 9-(b), and Fig. 10-(b) is a sectional view showing a manufacturing process subsequent to Fig. 10-(a);
Fig. 11 is a sectional view showing a photodiode array of a third embodiment of the present invention;
Fig. 12-(a) is a sectional view showing a manufacturing process of the photodiode array of Fig. 11, and Fig. 12-(b) is a sectional view of a subsequent manufacturing process; and
Fig. 13-(a) is a sectional view showing a manufacturing process subsequent to Fig. 12-(b), and Fig. 13-(b) is a sectional view showing a manufacturing process subsequent to Fig. 13-(a).

### Description of Symbols

1: Photodiode array
2: Semiconductor substrate
3: Transparent electrode layer
5: Separator
6: Avalanche multiplier (multiplier)
7: Accumulation layer
10: Photodetecting channel
51: Trench
52: Low-refractive-index material
42: Resistor
20, 22: Photodiode array

### Best Modes for Carrying Out the Invention

Hereinafter, preferred embodiments of the photodiode array relating to the present invention will be described in detail with reference to the drawings. The terms "upper," "lower," and the like are based on the state shown in the drawings, and are for descriptive purposes.

### [First embodiment]

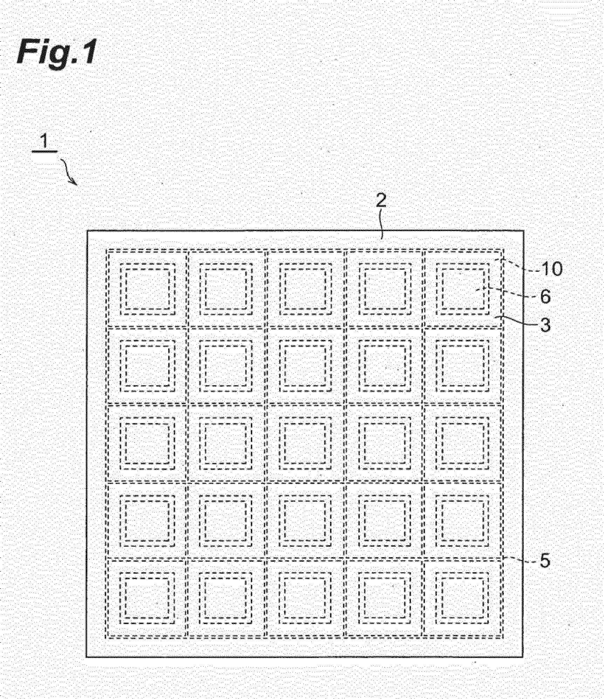

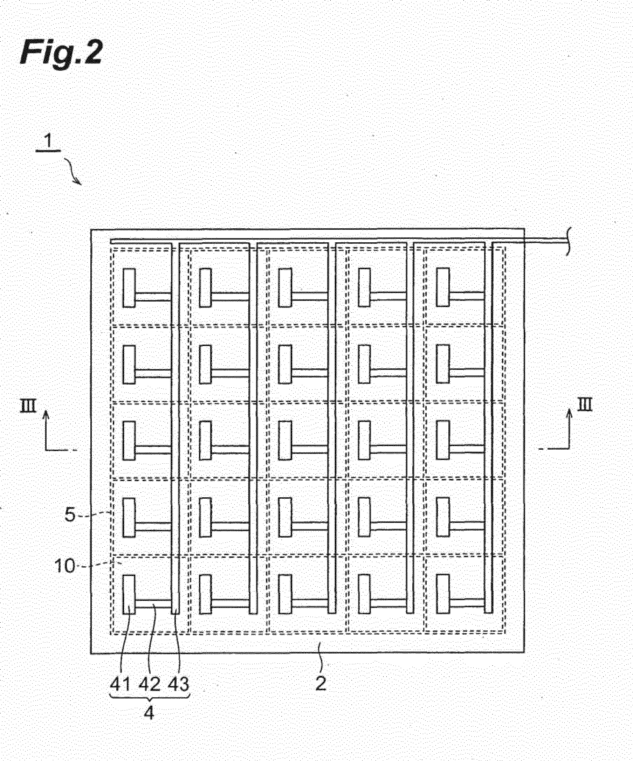

Fig. 1 is a view of a photodiode array 1 of a first embodiment of the present invention from an incident surface side for light to be detected, and Fig. 2 is a view of the photodiode array 1 from an opposite side of the incident surface.

As shown in Fig. 1 and Fig. 2, the photodiode array 1 includes a semiconductor substrate 2, a transparent electrode layer 3, and pattern wirings 4. The semiconductor substrate 2 is in a square shape whose one side is about 1 to 5 mm, on which photodetecting channels 10 divided into a matrix (in this embodiment, 5×5) are formed. Each photodetecting channel 10 is in a square shape whose one side is about 5 to 100 µm, and the photodetecting channels are separated from each other by separators 5 formed like a lattice. At central portions of the respective photodetecting channels 10, avalanche multipliers 6 in a predetermined pattern (rectangular pattern in this embodiment) for (electron) avalanche-multiplying carriers generated due to incidence of light to be detected are arranged, respectively.

The transparent electrode layer 3 is made of, for example, ITO (Indium Tin Oxide), and is formed on the entire lower surface side (incident surface side for light to be detected) of the semiconductor substrate 2. This transparent electrode layer 3 allows transmission of light to be detected, and is electrically connected as an anode to each photodetecting channel 10.

The pattern wiring 4 includes an electrode 41 and a resistor 42 formed for each photodetecting channel 10, and a wiring 43, and is formed on the upper surface side (opposite surface side of the incident surface side) of the semiconductor substrate 2. The electrodes 41 are made of, for example, Al, and are electrically connected as cathodes to the respective photodetecting channels 10. The resistors 42 are made of, for example, polysilicon, and are electrically connected to the respective photodetecting channels 10 via the electrodes 41. The wiring 43 is made of, for example, Al, and connects the electrodes 41 and the resistors 42 in parallel, and its output side is connected to an amplifying circuit (not shown). With this construction, this photodiode array 1 is constructed as a so-called multichannel photodetecting element.

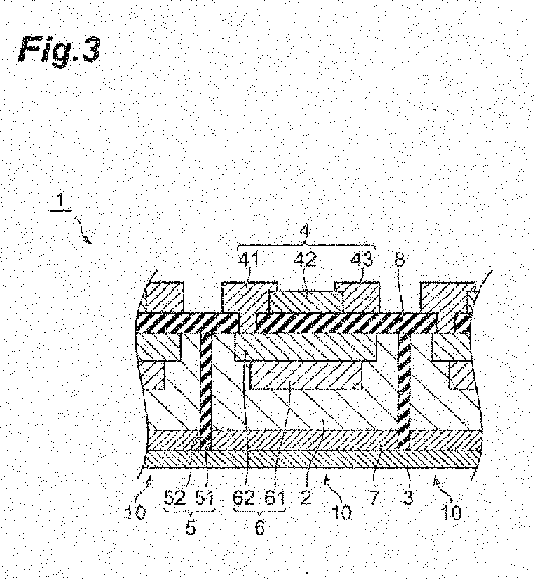

Next, a detailed construction of each photodetecting channel 10 will be described with reference to Fig. 3. Fig. 3 is a sectional view along the III-III line of Fig. 2.

As shown in Fig. 3, each photodetecting channel 10 includes the above-described semiconductor substrate 2, the avalanche multiplier 6 formed on the upper surface side of the semiconductor substrate 2, and an accumulation layer 7 formed on the lower surface side. The photodetecting channels 10 adjacent to each other are separated from each other by a separator 5.

The semiconductor substrate 2 is made of Si with a low impurity concentration whose conductivity type is p-type, and its thickness is set to 2 to 10 µm. The avalanche multiplier 6 includes a p-type semiconductor layer 61 made of Si whose conductivity type is p-type and an n⁺-type semiconductor layer 62 made of Si with a high impurity concentration whose conductivity is n-type. This p-type semiconductor layer 61 is formed into a rectangular shape (see Fig. 1) having a predetermined depth on the upper surface side of the semiconductor substrate 2, and has an impurity concentration higher than that of the semiconductor substrate 2. The n⁺-type semiconductor layer 62 is formed into a rectangular shape (see Fig. 1) larger than (or equal in shape to) the p-type semiconductor layer 61, on the upper surface side of the p-type semiconductor layer 61, and p-n junction is formed between the same and the p-type semiconductor layer 61. An insulating layer 8 made of, for example, SiO₂ is formed on the upper surface side of the n⁺-type semiconductor layer 62, and on this insulating layer 8, the pattern wiring 4 is formed. The n⁺-type semiconductor layer 62 is electrically connected to the electrode 41 as a cathode of the pattern wiring 4.

The accumulation layer 7 is made of Si which is higher in an impurity concentration than the semiconductor substrate 2 and whose conductivity type is p-type, and its thickness is set to 0.5 to 1.0 µm. This accumulation layer 7 is electrically connected to the transparent electrode layer 3 as an anode formed on the lower surface of the accumulation layer.

The separator 5 includes a trench 51 and a low-refractive-index material 52 formed in this trench 51. The trenches 51 are formed like a lattice so as to completely surround each avalanche multiplier 6, and the groove width thereof is not more than 5 µm. The low-refractive-index material 52 is made of SiO₂ in detail, and is formed into a layer with a refractive index (about 1.46) lower than that of the semiconductor substrate 2 and high insulation. These trench 51 and low-refractive-index material 52 are formed so as to penetrate the semiconductor substrate 2 from the upper surface side to the lower surface side in the thickness direction, and thereby, the photodetecting channels 10 and 10 adjacent to each other are electrically and optically separated from each other.

When the photodiode array 1 thus constructed is used for photo counting, it is operated under operating conditions called Geiger mode. During operation under this Geiger mode, a reverse voltage (for example, 40V or more) higher than the breakdown voltage is applied to each photodetecting channel 10 via the electrode 41 and the transparent electrode layer 3. In this state, when light to be detected enters each photodetecting channel 10 from the lower surface side, the light to be detected is absorbed in the semiconductor substrate 2 and generates carriers. The generated carriers move to the upper surface side while accelerating according to an electric field in the semiconductor substrate 2, and are multiplied to about 1×10⁶ times by each avalanche multiplier 6. Then, the multiplied carriers are extracted to the outside via the resistor 42 and the wiring 43 and detected based on a crest value of an output signal thereof.

As described above, in the photodiode array 1 relating to this embodiment, the resistors 42 and the wirings 43 to be electrically connected to the respective avalanche multipliers 6 are collectively formed on the upper surface side of the semiconductor substrate 2. Therefore, the lower surface side of the semiconductor substrate 2 which does not include interposition of the resistors 42 and the wirings 43 is set as the incident side of the light to be detected, whereby it becomes possible to narrow the gap between the photodetecting channels except for the forming region of the separator 5. As a result, in the photodiode array 1, a sufficient aperture ratio with respect to the light to be detected can be secured while crosstalk between the photodetecting channels 10 is restrained by the separator 5. Furthermore, on the lower surface side of the semiconductor substrate 2 as the incident surface side for light to be detected, the accumulation layer 7 having an impurity concentration higher than that of the semiconductor substrate 2 is formed for each photodetecting channel 10, so that carriers generated in the semiconductor substrate 2 due to incidence of the light to be detected can be restrained from being recombined near the lower surface of the semiconductor substrate 2. Thereby, high quantum efficiency in each photodetecting channel 10 is secured, so that the effective aperture ratio with respect to light to be detected is improved.

In the photodiode array 1, the separator 5 which separates photodetecting channels 10 adjacent to each other includes the trench 51 and the low-refractive-index material 52 formed in this trench 51. By this separator 5, it becomes possible to restrain electrical crosstalk caused by movement of carriers generated in the semiconductor substrate 2 due to incidence of light to be detected to the adjacent photodetecting channel 10. Furthermore, during operation in Geiger mode of the photodiode array 1, a reverse voltage higher than the breakdown voltage is applied to each avalanche multiplier 6, so that plasma emission may be generated when multiplying carriers, however, plasma emission generated at this time is reflected to the inside of the same photodetecting channel 10 due to a refractive index difference between the low-refractive-index material 52 and the semiconductor substrate 2. Thereby, the plasma emission can be effectively restrained from reaching the adjacent photodetecting channel 10, and optical crosstalk can also be restrained. In addition, by employing the trench 51 for forming the separator 5, the width of the separator 5 can be formed to be not more than 5 µm, so that the gap between the photodetecting channels 10 is hardly expanded, and an aperture ratio with respect to light to be detected is secured.

By forming the low-refractive-index material 52 from SiO₂, the above-described crosstalk restraining effect becomes more conspicuous. That is, SiO₂ has high insulation, so that electrical crosstalk is more effectively restrained. The refractive index of SiO₂ is about 1.46, and the refractive index of the semiconductor substrate 2 made of Si is about 3.5 to 5.0, so that a sufficient refractive index difference is secured between the lower-refractive-index material 52 and the semiconductor substrate 2. Therefore, plasma emission can be more reliably reflected by the low-refractive-index material 52, and optical crosstalk is more effectively restrained. Furthermore, the trench 51 and the low-refractive-index material 52 are formed so as to penetrate the semiconductor substrate 2 from the upper surface side to the lower surface side, so that the photodetecting channels 10 adjacent to each other are more reliably separated from each other. This is especially effective for blocking plasma emission radiating in all directions from the respective avalanche multipliers 6 during operation in Geiger mode, and optical crosstalk can be more reliably restrained.

Furthermore, in the photodiode array 1, in the respective photodetecting channels 10, the accumulation layers 7 formed on the lower surface side of the semiconductor substrate 2 are electrically connected to each other by the transparent electrode layer 3. Thereby, the photodetecting channels 10 are conducted to each other by the transparent electrode layer 3, and the same potential can be maintained. The accumulation layers 7 lower the contact resistance between the semiconductor substrate 2 and the transparent electrode layer 3 and make it possible to form a satisfactory contact.

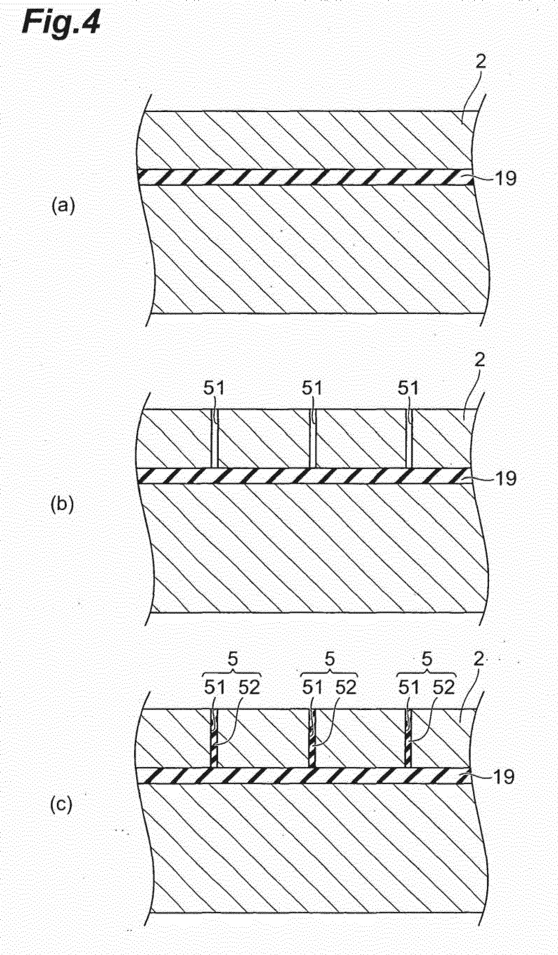

To manufacture the photodiode array 1 having the above-described construction, first, as shown in Fig. 4-(a), a SOI (Silicon on insulator) substrate whose conductivity type is p-type and which has an intermediate insulating layer 19 is prepared as the semiconductor substrate 2. Next, by etching using a predetermined mask (not shown), as shown in Fig. 4-(b), the lattice-like trenches 51 are formed so as to reach the upper surface of the intermediate insulating layer 19 from the upper surface of the SOI substrate to form photodetecting channels 10 into a matrix. Furthermore, for example, by sputtering, as shown in Fig. 4-(c), the low-refractive-index material 52 is embedded in the entire trenches 51 to form the separators 5.

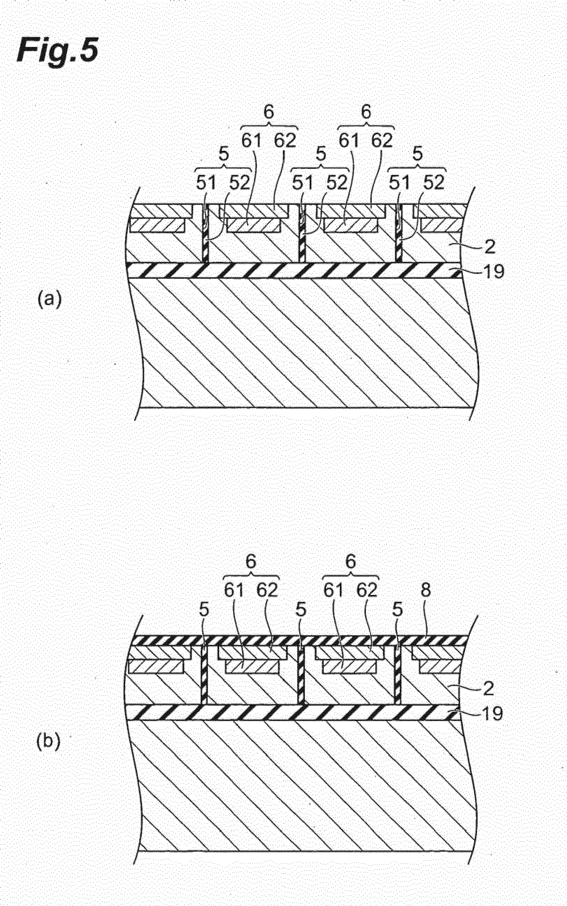

Next, as shown in Fig. 5-(a), in each photodetecting channel 10, a p-type impurity such as B (boron) is doped and diffused from the upper surface side of the semiconductor substrate 2, and a p-type semiconductor layer 61 with a predetermined thickness is formed on the upper surface side of this semiconductor substrate 2. Furthermore, an n-type impurity such as P (phosphorus) is doped and diffused from the upper surface side of this p-type semiconductor layer 61, and on the upper surface side of the p-type semiconductor layer 61, an n⁺-type semiconductor layer 62 with a predetermined thickness is formed. Thereby, avalanche multipliers 6 are formed on the upper surface side of the semiconductor substrate 2. Then, as shown in Fig. 5-(b), an insulating layer 8 is formed on the upper surface of the semiconductor substrate 2 by using, for example, thermal oxidation. In this embodiment, the process of forming the avalanche multipliers 6 may be performed prior to the process of forming the separators 5.

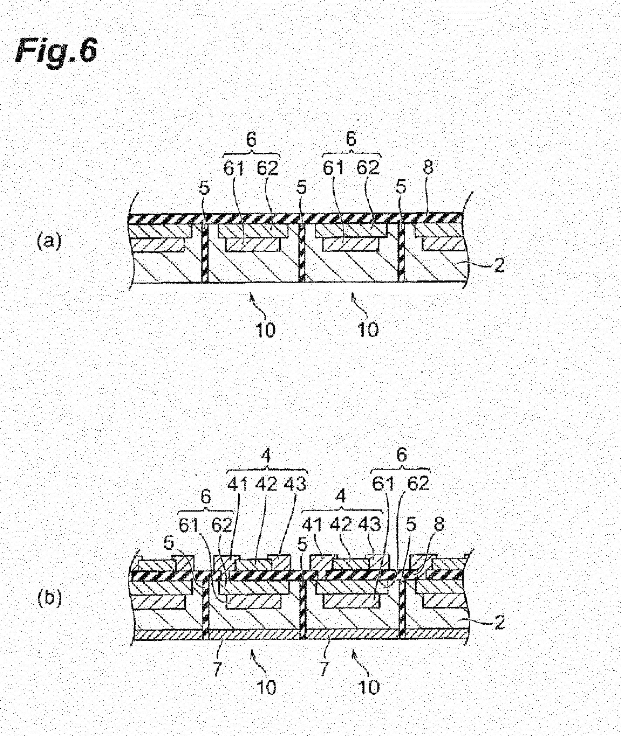

Furthermore, as shown in Fig. 6-(a), the intermediate insulating layer 19 of the SOI substrate and the silicon layer on the lower surface side than the intermediate insulating layer 19 are removed by etching to expose the lower surface side of the semiconductor substrate 2. Next, as shown in Fig. 6-(b), a p-type impurity such as B (boron) is doped and diffused from the lower surface side of the semiconductor substrate 2 to form an accumulation layer 7 for each photodetecting channel 10, and necessary portions of the insulating layer 8 are holed by using a photoresist, and then pattern wirings 4 are formed by sputtering or vapor deposition on the upper surface of the insulating layer 8. After forming the pattern wirings 4, a transparent electrode layer 3 is formed last by, for example, vapor deposition on the lower surface sides of the accumulation layers 7 to electrically connect the accumulation layers 7 to each other, whereby the multichannel type photodiode array 1 shown in Fig. 1 through Fig. 3 is completed.

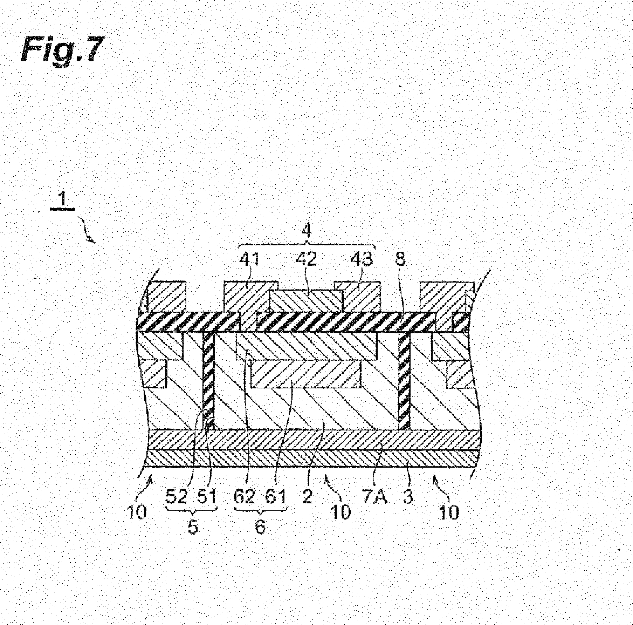

Various variations may be applied to the layers of this embodiment. For example, the p-type semiconductor layer 61 in each avalanche multiplier 6 may be formed to have a thickness reaching the accumulation layer 7, and the resistor 42 may be formed so as to overlap the n⁺-type semiconductor layer 62 via the insulating layer 8. Instead of forming the accumulation layer 7 for each photodetecting channel 10, as shown in Fig. 7, an accumulation layer 7A may be formed on the entire lower surface side of the semiconductor substrate 2. Furthermore, on the peripheral portion of each avalanche multiplier 6, a guard ring made of a semiconductor layer whose conductivity type is n-type may be formed. Thereby, the avalanche multiplier 6 can be protected from a leak of a high voltage by the guard ring, and uniform avalanche multiplication at the p-n junction is obtained. The shapes of the trenches 51 shown have the same width from the upper surface side to the lower surface side of the semiconductor substrate 2, however, without limiting to this, they may be formed into a shape whose width becomes wider on the upper surface (n⁺-type semiconductor layer 62 surface) side than on the lower surface (light-incident surface) side, and vice versa.

### [Second embodiment]

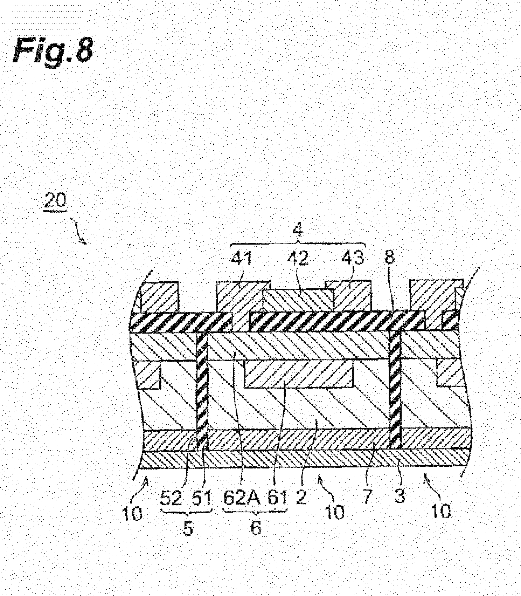

From the first embodiment having the n⁺-type semiconductor layer 62 formed only at the center of each photodetecting channel 10, the photodiode array 20 of the second embodiment is different in that the n⁺-type semiconductor layer 62A forming each avalanche multiplier 6 is formed over the entire surface of each photodetecting channel 10 and is in contact with the surrounding separators 5 as shown in Fig. 8.

Also in this photodiode array 20, as in the first embodiment, the resistors 42 and wirings 43 thereof to be electrically connected to the respective avalanche multipliers 6 are collectively formed on the upper surface side of the semiconductor substrate 2, so that by setting the lower surface side of the semiconductor substrate 2 as an incident side of light to be detected, the gaps between the photodetecting channels 10 can be narrowed except for the forming regions of the separators 5. As a result, a sufficient aperture ratio with respect to light to be detected can be secured while restraining crosstalk between the photodetecting channels 10 by the separators 5. Furthermore, on the lower surface side of the semiconductor substrate 2 as an incident side of light to be detected, the accumulation layers 7 are formed, so that high quantum efficiency in each photodetecting channel 10 is secured, and an effective aperture ratio with respect to light to be detected is improved.

Also in the photodiode array 20, by the separators 5 constructed in the same manner as in the first embodiment, electrical crosstalk and optical crosstalk can be effectively restrained. In addition, the employment of trenches 51 for forming the separators 5 hardly expand the gaps between the photodetecting channels 10, and an aperture ratio with respect to light to be detected is secured.

Furthermore, also in the photodiode array 20, the accumulation layers 7 are electrically connected to each other by the transparent electrode layer 3. Thereby, the photodetecting channels 10 are conducted to each other, and the same potential can be maintained. The accumulation layers lower the contact resistance between the semiconductor substrate 2 and the transparent electrode layer 3 and make it possible to form a satisfactory contact.

To manufacture such a photodiode array 20, first, in the same manner as in the manufacturing processes shown in Fig. 4-(a) through Fig. 4-(c), the separators 5 and photodetecting channels 10 are formed in the SOI substrate prepared as the semiconductor substrate 2.

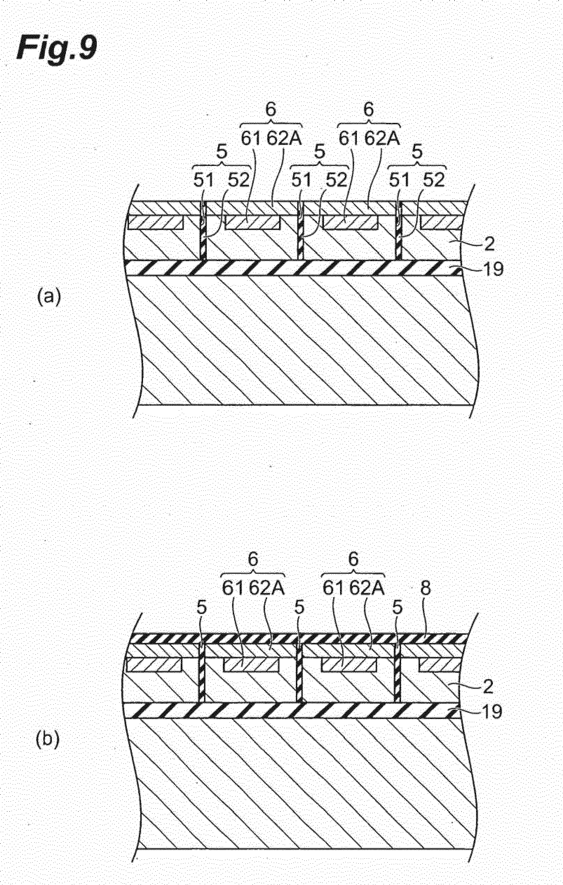

Next, as shown in Fig. 9-(a), a p-type impurity such as B (boron) is doped and diffused from the upper surface side of the semiconductor substrate 2 to form p-type semiconductor layers 61 with a predetermined thickness on the upper surface side of the semiconductor substrate 2. Furthermore, an n-type impurity such as P (phosphorus) is doped and diffused for the entire surfaces of the photodetecting channels 10 from the upper surface side of the p-type semiconductor layers 61 to form n⁺-type semiconductor layers 62A with a predetermined thickness on the upper surface side of the p-type semiconductor layers 61. Thereby, avalanche multipliers 6 are formed on the upper surface side of the semiconductor substrate 2. In this embodiment, the process of forming the avalanche multipliers 6 may be performed prior to the process of forming the separators 5.

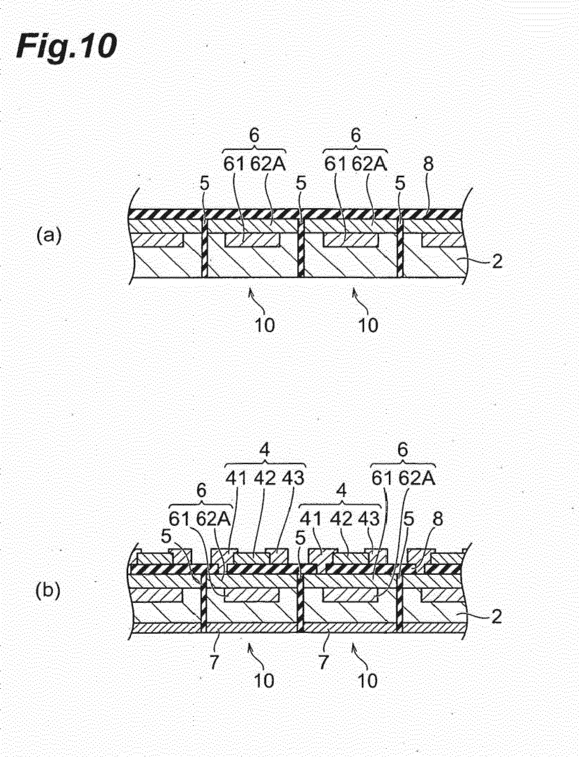

Next, an insulating layer 8 is formed on the upper surface of the semiconductor substrate 2 by using, for example, thermal oxidation as shown in Fig. 9-(b). Then, as shown in Fig. 10-(a), the intermediate insulating layer 19 of the SOI substrate and a silicon layer on the lower surface side than the intermediate insulating layer 19 are removed by etching to expose the lower surface side of the semiconductor substrate 2. Next, as shown in Fig. 10-(b), a p-type impurity such as B (boron) is doped and diffused from this exposed lower surface side of the semiconductor substrate 2 to form an accumulation layer 7 for each photodetecting channel 10, and furthermore, necessary portions of the insulating layer 8 are holed by using a photoresist, and then pattern wirings 4 are formed by, for example, sputtering or vapor deposition. After forming the pattern wirings 4, a transparent electrode layer 3 is formed last by, for example, vapor deposition on the lower surface sides of the accumulation layers 7 to electrically connect the accumulation layers 7 to each other, whereby the so-called multichannel type photodiode 20 shown in Fig. 8 is completed.

Various variations can also be applied to the layers of this embodiment. For example, the p-type semiconductor layers 61 may be formed so as to have a thickness reaching the accumulation layers 7, and the resistors 42 may be formed so as to overlap the n⁺ semiconductor layers 62A via the insulating layer 8. Instead of the accumulation layers 7, an accumulation layer 7A formed on the entire lower surface side of the semiconductor substrate 2 may be employed as shown in Fig. 7. The shapes of the trenches 51 shown have the same width from the upper surface side to the lower surface side of the semiconductor substrate 2, however, without limiting to this, they may be formed into a shape whose width becomes wider on the upper surface (n⁺-type semiconductor layer 62A surface) side than on the lower surface (light-incident surface) side, and vice versa.

### [Third embodiment]

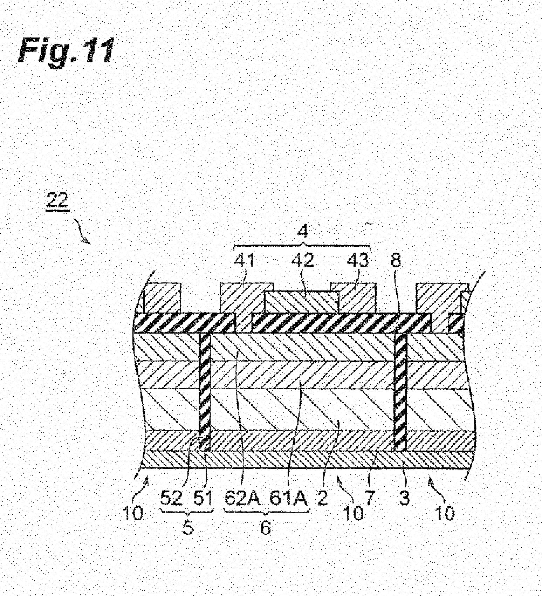

From the first embodiment having the p-type semiconductor layers 61 and the n⁺-type semiconductor layers 62 formed only at the centers of the photodetecting channels 10, a photodiode array 22 according to a third embodiment is different in that both of the p-type semiconductor layers 61A and n⁺-type semiconductor layers 62A forming the avalanche multipliers 6 are formed over the entire surfaces of the photodetecting channels 10 and are in contact with the surrounding separators 5 as shown in Fig. 11.

Also in this photodiode array 22, as in the case of the first embodiment, the resistors 42 and wirings 43 thereof to be electrically connected to the respective avalanche multipliers 6 are collectively formed on the upper surface side of the semiconductor substrate 2, so that by setting the lower surface side of the semiconductor substrate 2 as an incident side of light to be detected, the gaps between the photodetecting channels 10 can be narrowed except for the forming regions of the separators 5. As a result, while restraining crosstalk between the photodetecting channels 10 by the separators 5, a sufficient aperture ratio with respect to light to be detected can be secured. Furthermore, on the lower surface side of the semiconductor substrate 2 as an incident side of light to be detected, accumulation layers 7 are formed, so that high quantum efficiency in each photodetecting channel 10 is secured, and an effective aperture ratio with respect to light to be detected is improved.

Also in the photodiode array 22, electrical crosstalk and optical crosstalk can be effectively restrained by the separators 5 formed in the same manner as in the first embodiment. In addition, the employment of trenches 51 for forming the separators 5 hardly expands the gaps between the photodetecting channels 10, and an aperture ratio with respect to light to be detected is secured.

Furthermore, also in the photodiode array 22, the accumulation layers 7 are electrically connected to each other by the transparent electrode layer 3. Thereby, the photodetecting channels 10 are conducted to each other by the transparent electrode layer 3, and the same potential can be maintained. The accumulation layers lower the contact resistance between the semiconductor substrate 2 and the transparent electrode layer 3 and make it possible to form a satisfactory contact.

To manufacture such a photodiode array 22, first, in the same manner as in the manufacturing processes shown in Fig. 4-(a) through Fig. 4-(c), the separators 5 and the photodetectig channels 10 are formed in an SOI substrate prepared as the semiconductor substrate 2.

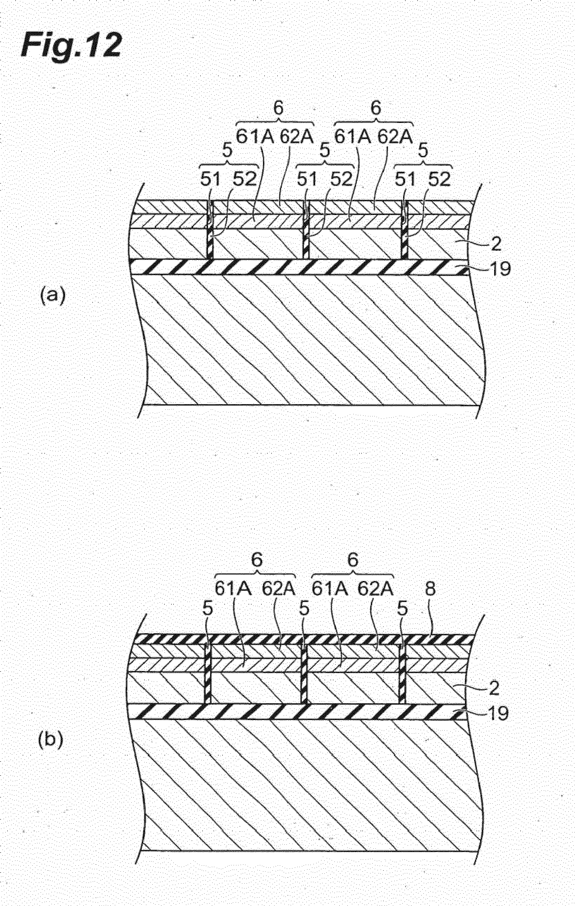

Next, as shown in Fig. 12-(a), a p-type impurity such as B (boron) is doped and diffused for the entire surface from the upper surface side of the semiconductor substrate 2 to form p-type semiconductor layers 61A with a predetermined thickness on the upper surface side of this semiconductor substrate 2. Furthermore, from the upper surface sides of this p-type semiconductor layers 61A, an n-type impurity such as P (phosphorus) is doped and diffused for the entire surfaces of the photodetecting channels 10 to form n⁺-type semiconductor layers 62A with a predetermined thickness on the upper surface sides of the p-type semiconductor layer 61A. Thereby, on the upper surface side of the semiconductor substrate 2, avalanche multipliers 6 are formed. Also in this embodiment, the process of forming the avalanche multipliers 6 may be performed prior to the process of forming the separators 5.

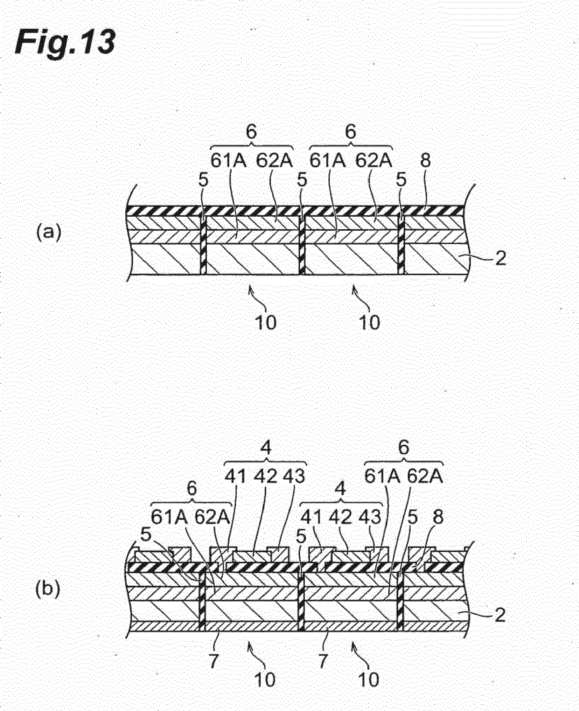

Next, as shown in Fig. 12-(b), an insulating layer 8 is formed on the upper surface of the semiconductor substrate 2 by using, for example, thermal oxidation. As shown in Fig. 13-(a), the intermediate insulating layer 19 of the SOI substrate and the silicon layer on the lower surface side than the intermediate insulating layer 19 are removed by etching to expose the lower surface side of the semiconductor substrate 2. Next, as shown in Fig. 13-(b) a p-type impurity such as B (boron) is doped and diffused from this exposed lower surface side of the semiconductor substrate 2 to form an accumulation layer 7 for each photodetecting channel 10, and furthermore, necessary portions of the insulating layer 8 are holed by using a photoresist, and then pattern wirings 4 are formed on the upper surface of the insulating layer 8 by, for example, sputtering or vapor deposition. After forming the pattern wirings 4, a transparent electrode layer 3 is formed last on the lower surface sides of the accumulation layers 7 by, for example, vapor deposition to electrically connect the accumulation layers 7 to each other, whereby the so-called multichannel type photodiode array 22 shown in Fig. 11 is completed.

Also to the layers of this embodiment, various variations can be applied. For example, the p-type semiconductor layers 61A may be formed so as to have a thickness reaching the accumulation layers 7, and the resistors 42 may be formed so as to overlap the n⁺ semiconductor layers 62A via the insulating layer 8. Instead of the accumulation layers 7, as shown in Fig. 7, an accumulation layer 7A may be formed on the entire lower surface side of the semiconductor substrate 2. The shapes of the trenches 51 shown have the same width from the upper surface side to the lower surface side of the semiconductor substrate 2, however, without limiting to this, they may be formed so as to have a width which becomes wider on the upper surface (n⁺-type semiconductor layer 62A surface) side than on the lower surface (light-incident surface) side, and vice versa.

### Industrial Applicability

The present invention is usable for a photodiode array which is used for photon counting by being operated in Geiger mode.

## Claims

1. A photodiode array (1, 20, 22) comprising:
a plurality of photodetecting channels (10) which are formed in a semiconductor substrate (2) and light to be detected is made to enter;
an accumulation layer (7A) or accumulation layers (7) having an impurity concentration higher than in the semiconductor substrate (2), the accumulation layer (7A) or the accumulation layers (7) formed at an incident surface side of the semiconductor substrate (2), the accumulation layers (7) being electrically connected to each other;
PN junctions of multipliers formed at an opposite surface side of the incident surface of the semiconductor substrate (2), each of the multipliers avalanche-multiplying carriers;
resistors (42), each formed on the opposite surface side of the incident surface and electrically connected to the multipliers; and
separators (5) formed around and separating the photodetecting channels (10),
the accumulation layers (7), the multipliers (6) and the resistors (42) being respectively formed for each of the respective photodetecting channels (10), or the accumulation layer (7A) being formed over an entire surface of the incident surface side of the semiconductor substrate (2) while the multipliers (6) and the resistors (42) being respectively formed for each of the respective photodetecting channels (10).

2. The photodiode array (1, 20, 22) according to claim 1, wherein the separators (5) are formed by trenches.

3. The photodiode array (1, 20, 22) according to claim 2, wherein in the trenches, a low-refractive-index material having a refractive index lower than that of the semiconductor substrate (2) is formed.

4. The photodiode array (1, 20, 22) according to claim 3, wherein the low-refractive-index material is made of SiO₂.

5. The photodiode array according to claim 4, wherein the trench (5) and the low-refractive-index material are formed so as to penetrate the semiconductor substrate (2) from the incident surface side to the opposite surface side.

6. The photodiode array according to any one of claims 1 to 5, wherein the conductivity type of the accumulation layer (7A) or the accumulation layers (7) is the same as the conductivity type of the semiconductor substrate (2).

7. The photodiode array according to any one of claims 1 to 6, wherein the resistors (42) are connected in parallel.

8. The photodiode array according to any one of claims 1 to 7, wherein the separators (5) are formed around and separating the multipliers.
